# EUROPEAN PATENT APPLICATION

(11) **EP 4 746 679 A1**
(43) Date of publication of application: **20.05.2026**
(21) Application number: 25214513.1
(22) Date of filing: 10.11.2025
(51) Int. Cl.: H10W 74/01, H10W 70/40, H10W 70/04, H10W 40/25, H10W 74/10, H10W 72/00

(54) **PRESSFIT TERMINAL FOR ISOLATED POWER SEMICONDUCTOR DEVICES**

(30) Priority: 13.11.2024 US 202418946694
(71) Applicant: Littelfuse, Inc., Rosemont, Illinois 60018 (US)
(72) Inventor: Maldo, Tiburcio A., Rosemont, IL 60018 (US); Grozen, Jeff, Rosemont, IL 60018 (US); Deveza, Arnel, Rosemont, IL 60018 (US); Spann, Thomas, Rosemont, IL 60018 (US); Cadut, Roger, Rosemont, IL 60018 (US); Hughes, Rhodri, Rosemont, IL 60018 (US)
(74) Representative: Arnold & Siedsma

(57) **Abstract**

A method for forming a semiconductor package. The method may include performing a lead attachment operation, comprising attaching at least one lead directly to a substrate that is configured to support one or more semiconductor die, wherein the at least one lead is attached to the substrate in singulated fashion.

## Description

### Background

### Field

The disclosure relates to the field of semiconductor devices, and in particular, packages for power semiconductor chips.

### Discussion of Related Art

Semiconductor device packages (or simply, "semiconductor packages") such as power modules or discrete packages may include components such as semiconductor chips, substrates, and connectors, where the latter may include wires, clips, and other connectors. In particular, in power semiconductor packages, power chips may be included such as thyristors, field effect transistors (FETs), insulated gate bipolar transistors (IGBTs), and auxiliary chips, including diodes. A main purpose of clips is to electrically connect these chips to one another or to substrates.

In discrete semiconductor device package manufacturing, it is common to have a leadframe structure to form the so called the backbone of a semiconductor package. During assembly of a semiconductor package, the leadframe may be connected to metalized substrates that support semiconductor die, for example. The structure of a leadframe may be characterized by a metallic frame or support portion, as well as lead portions that may be defined within the frame. The leadframe may be assembled to a substrate such that the different lead portions are aligned and make contact with metallic features in a substrate, in order to create electrical connections to deliver control and power signals to the semiconductor devices supported by a substrate. The lead portions and frame portion may form a continuous structure that is monolithic and electrically interconnected, so that individual leads are not electrically isolated from one another.

After assembly to a substrate, the lead frame may be trimmed to remove the frame portion, as well as to singulate electrical leads from one another, meaning to remove the portions of the lead frame that initially connect the lead portions to one another, so that each lead becomes a stand along structure. This singulation is especially needed in order to electrically isolate particular leads from one another in the case where different leads are to electrically couple to different terminals of a semiconductor device, for example.

In view of the above, it may be appreciated that the process of connecting electrical leads to a semiconductor package using a lead frame structure is rather involved.

In view of the above, the present disclosure is provided.

### Brief Summary

A method for forming a semiconductor package is provided. The method may include performing a lead attachment operation, comprising attaching at least one lead directly to a substrate that is configured to support one or more semiconductor die, wherein the at least one lead is attached to the substrate in singulated fashion.

A semiconductor package assembly apparatus is provided. The apparatus may include a substrate clamp assembly, and a mold structure, at least partially encasing the substrate clamp assembly, wherein the mold structure comprises a top leadguide block, arranged to prevent mold bleeding during a molding operation.

A semiconductor substrate assembly is provided, for forming a semiconductor device package. The semiconductor substrate assembly may include a substrate, comprising a ceramic body and a set of metal layers attached to the ceramic body, and a set of leads, attached to the substrate, wherein the set of leads are adjoined to the substrate through a laser weld.

### Brief Description of the Drawings

**FIG. 1A** illustrates a top view of a semiconductor substrate assembly, according to the present disclosure;
**FIG. 1B** illustrates a top view of another semiconductor substrate assembly, according to the present disclosure;
**FIG. 1C** illustrates a top isometric view of a lead, according to the present disclosure;
**FIG. 1D** illustrates a top view of the lead of FIG. 1C;
**FIG. 1E** illustrates a side view of the lead of FIG. 1C;
**FIG. 1F** illustrates a top isometric view of another lead, according to the present disclosure;
**FIG. 1G** illustrates a top view of the lead of FIG. 1F;
**FIG. 1H** illustrates a side view of the lead of FIG. 1F;
**FIG. 2A** depicts a top plan view of a semiconductor substrate assembly;
**FIG. 2B** depicts a top plan view of the semiconductor substrate assembly of FIG. 2A after assembly of a set of leads, in accordance with the disclosure;
**FIG. 2C** depicts a top plan view of the semiconductor device assembly of FIG. 2B after wire bonding;
**FIG. 2D** depicts a top plan view of the semiconductor device assembly of FIG. 2C after formation of a molded housing;
**FIG. 2E** depicts a top plan view of the semiconductor device assembly of FIG. 2D after plating of the set of leads;
**FIGs. 3A-3K** depict various stages during the assembly of a semiconductor device package assembly, according to the disclosure;
**FIG. 4** depicts a side cross-sectional view of a transfer mold design, according to the disclosure;
**FIG. 5A** depicts a top perspective view of a portion of the structure of FIG. 4;
**FIG. 5B** depicts an enlarged view of a pinch bar section of the structure of FIG. 5A;
**FIG. 6A** depicts a top isometric view of a semiconductor device package, according to the present disclosure;
**FIG. 6B** depicts an enlarged view of a lead portion of the semiconductor device package of FIG. 6A;
**FIG. 7A** depicts a photographic image view of a testing operation ;
**FIG. 7B** depicts a photographic image view of another testing operation;
**FIG. 7C** depicts a photographic image view of another testing operation;
**FIG. 8A** depicts a leadframe assembly with attached semiconductor substrate assembly;
**FIG. 8B** depicts the semiconductor substrate assembly of FIG. 8A after trim and singulation;
**FIG. 9A** is a composite view that depicts a top view and side view of an assembly with a semiconductor substrate package and attached leads, as well as views of a single lead, according to the disclosure;
**FIG. 9B** depicts the assembly of FIG. 9A after a forming operation;
**FIG. 9C** depicts a top isometric view of the assembly of FIG. 9B at a final stage;
**FIG. 10** depicts a side cross-sectional view of a mold tool layout, according to the disclosure; and
**FIG. 11** presents an exemplary process flow.

### Description

The present disclosure will now be described more fully hereinafter with reference to the accompanying drawings.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "neither", and/or it may mean "both", although the scope of claimed subject matter is not limited in this respect.

A novel semiconductor device package and method of assembly are provided. As detailed below, a semiconductor device package with attached leads may be assembled through a process without lead frames, thus enabling fewer process steps, less manufacturing and packaging cost than existing designs, and better performance including reliability, for the types of packages that in particular includes isolated semiconductor device packages.

As further detailed below, employing a combination of features, including at least one of: press fit terminal leads, laser welding to join leads directly to a AMB/DCB substrate, and the use of lead-free die attached material, packages that_suitable for power semiconductor devices may be achieved, including for Wide Band Gap Semiconductor requirements to address high voltage, high current, high thermal conductivity and higher operating temperature > 175 ° C applications.

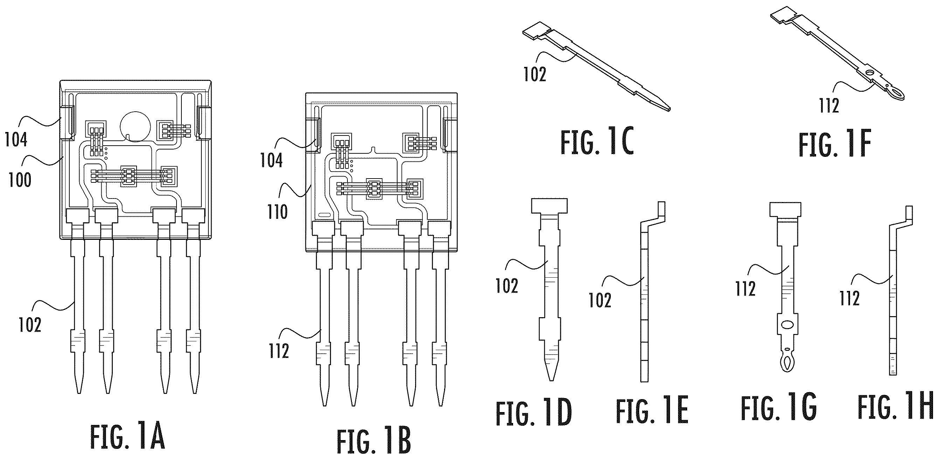

**FIG. 1A** illustrates a top view of a semiconductor substrate assembly 100, according to the present disclosure. The semiconductor substrate assembly 100 includes a substrate section 104, and a set of leads, shown as leads 102. In this case, the leads 102 represent a universal standard terminal. **FIG. 1B** illustrates a top view of another semiconductor substrate assembly 110, according to the present disclosure. In this case, the leads 112 represent a universal press fit terminal. **FIG. 1C** illustrates a top isometric view of a lead 102, according to the present disclosure; **FIG. 1D** illustrates a top view of the lead of FIG. 1C; while **FIG. 1E** illustrates a side view of the lead of FIG. 1C.

**FIG. 1F** illustrates a top isometric view of a lead 112, according to the present disclosure; **FIG. 1G** illustrates a top view of the lead of FIG. 1F; while **FIG. 1H** illustrates a side view of the lead of FIG. 1F. As detailed in the description to follow, these semiconductor package assemblies may be formed without a lead frame structure, and by a welding process in particular. Thus, for example, the 'universal standard terminal' structure of FIG. 1C or the 'universal press fit terminal' structure of FIG. 1F may be fabricated precisely for use as individual leads in semiconductor packages, such as in isolated power device packages. Said differently, the leads are attached in 'singulated' fashion, where any given lead is not attached to any other lead.

The combination of employing a Press Fit Terminal lead that is joined by laser welding directly to a substrate such as an active metal brazing (AMB), direct copper bonded (DCB) substrate, or direct aluminum bonded (DAB) substrate, with a Lead-Free Die Attached Material may be suitable for Wide Band Gap Semiconductor requirements, to address High Voltage, High Current, High Thermal conductivity and Higher Operating Temperature > 175 ° C applications. In particular, advantages provided using press-fit connections without using a lead frame include a Low thermal load for components; assembly of power modules at the bottom side of a printed circuit board (PCB); prevention of solder bridges, splashes and flux residues; connections may be lead-free and halogen free; good current carrying capability; high long term reliability; good cost effectiveness; and low assembly costs.

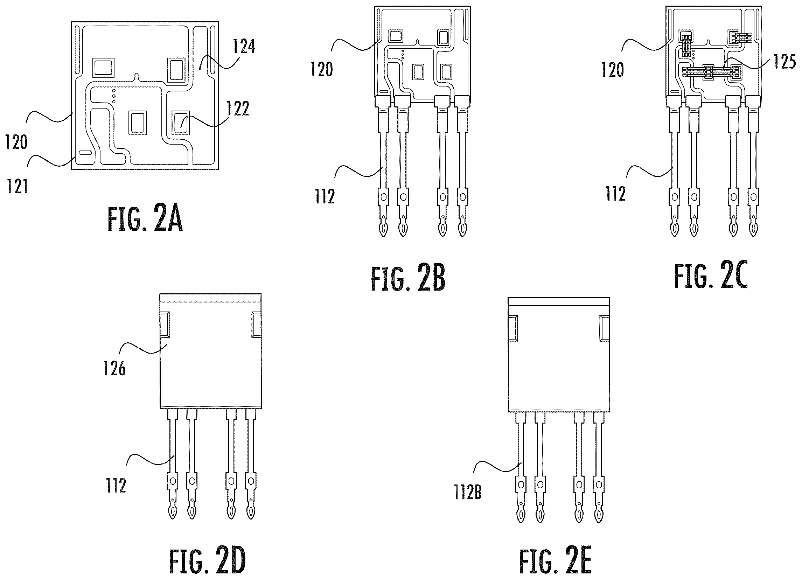

**FIG. 2A** depicts a top plan view of a semiconductor substrate assembly 120, including a substrate 121, which substrate may be a DCB substrate or DAB substrate of other substrate as known in the art. The substrate 121 may have a ceramic body and a metallization pattern 124 for forming contacts to semiconductor die 122.

**FIG. 2B** depicts a top plan view of the semiconductor substrate assembly of FIG. 2A after assembly of a set of leads, in this case, leads 112, in accordance with the disclosure. **FIG. 2C** depicts a top plan view of the semiconductor device assembly of FIG. 2B after formation of wire bonding 125. The semiconductor die 122 may be a SiC chip, while the substrate 121 is a Si₃N₄ substrate with metallization formed by joining a metal layer to the Si₃N₄ substrate using an active metal brazing (AMB) process, where the chip-to-substrate adhesive is realized by Ag sintering, the leads 112 are a universal press fit type structure, and bond wires formed with aluminum wire. Standard high Pb-content metallization may be used for joining substrate and chip. The leads 112 may be joined to the substrate using laser welding. The wire bonding 125 may employ Al wires.

**FIG. 2D** depicts a top plan view of the semiconductor device assembly of FIG. 2C after formation of a molded housing 126. **FIG. 2E** depicts a top plan view of the semiconductor device assembly of FIG. 2D after plating of the set of leads. In particular, after the molding operation, the leads may be processed to present a bare copper surface, for better solderability during mounting on a PCB board. The plating of the leads may then take place using a known plating process, such as tin plating.

After the plating of the leads, a Skew Tool assembly may be provided for lead conditioning at a final testing ( FT ) station or at an offline Tool to correct bent leads for a long lead semiconductor device assembly. Because the semiconductor packages of the present disclosure do not have a leadframe, the terminal leads are prone to bending during processing, such as during the plating process. Accordingly, additional lead conditioning may take place in the FT station, or may be performed with a specialized conditioning tool, or performed offline before final electrical testing.

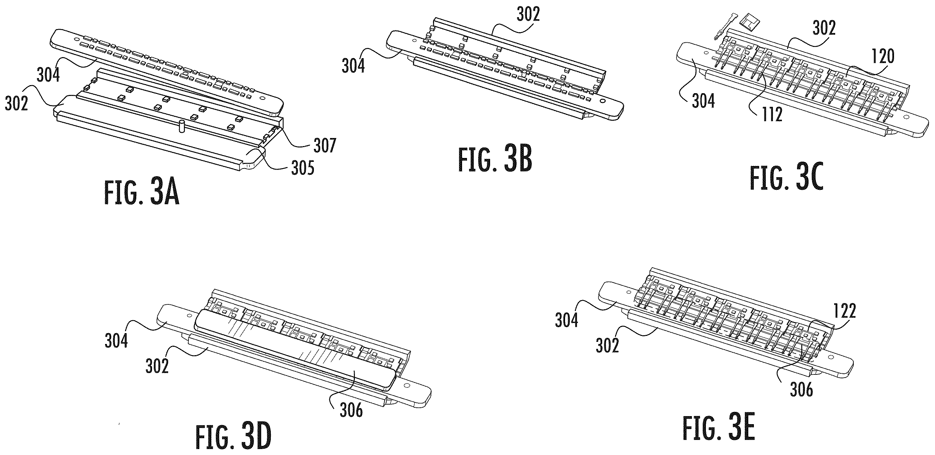

**FIGs. 3A-3L** depict various stages during the assembly of a semiconductor device package assembly, according to the disclosure. At FIG. 3A, a assembly holder 302 is provided, to hold and align substrates, such as DCB substrates, during assembly of a semiconductor package or array of packages. The assembly holder 302 includes a terminal aligner slot 305 to accommodate a terminal aligner insert 304, and a substrate slot 307 to accommodate substrates in particular. Note that the terminal aligner insert 304 may include an embedded magnet that facilitates coupling to a clamp, as described with respect to FIG. 3D to follow. At **FIG. 3B****,** the terminal aligner insert 304 is disposed within the terminal aligner slot 305. Note that the terminal aligner insert 304 functions to align and space out a set of leads that are connected to respective substrates, as shown in **FIG. 3C****,** where substrates 121, with leads 112 are disposed within the assembly holder 302. Note that, the assembly holder 302 may alternatively accommodate a substrate assembly 110, or similar substrate assembly. In brief, and with reference also to FIGs. 2B and FIG. 2C, at the stage of FIG. 3C, a set of the substrates 121 have been placed in the substrate slot 307. The leads 112 have been placed within lead recesses provided in the terminal aligner insert 304, and are aligned to the respective substrates in the substrate slot 307. Semiconductor die 122 have been placed and attached to the respective substrates, as shown.

**FIG. 3D** depicts a subsequent instance of assembly, where a clamp 306 is placed over the terminal aligner insert 304. The clamp 306 may be a Magnetic Weight Jig or any suitable structure to clamp the leads 112 during an assembly process, such as a Vacuum Reflow process. In particular, the clamp 306 may be magnetic to magnetically clamp to the terminal aligner insert 304. **FIG. 3E** depicts a subsequent instance after wire bonding has taken place for forming wire bonds between various components, such as semiconductor die, and substrate, as shown in FIG. 2C. Note that the wirebonding takes place while the components are held in the assembly holder 302.

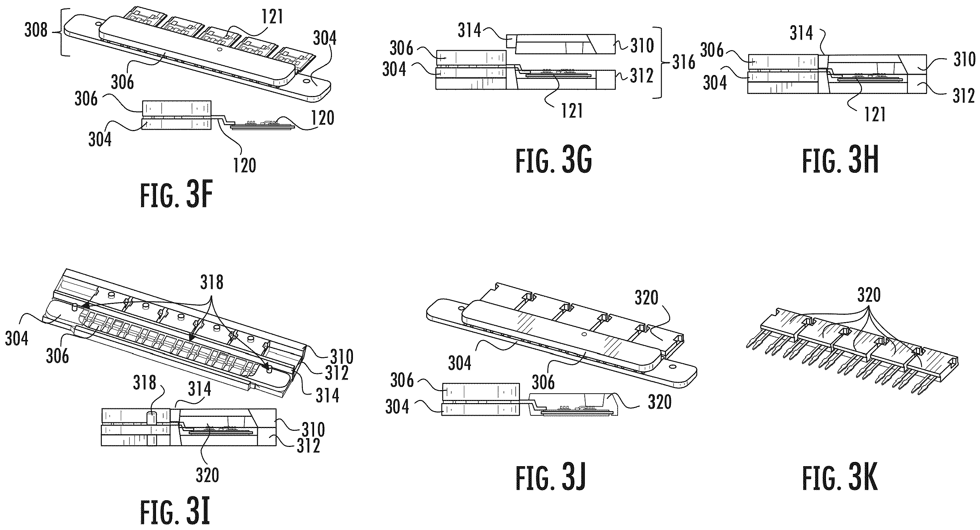

**FIG. 3F** is a composite view including perspective view and cross-sectional view that depicts a subsequent instance where terminal aligner insert 304 and clamp 306 are together removed from the assembly holder 302. Note that the terminal aligner insert 304 and clamp 306 together hold the substrates 121 and attached leads, leads 112, as shown in the cross-sectional view of FIG. 3F. The terminal aligner insert 304 and clamp 306 form a substrate clamp assembly 308 for holding the leads 112 and substrates 121, so the clamped leads and substrates can subsequently be loaded into a mold structure for forming the housing of semiconductor packages to be fabricated.

**FIG. 3G** depicts a subsequent instance where the substrate clamp assembly 308 is arranged in a mold structure 316 for molding. In particular, the set of substrates 121 are arranged into a bottom mold frame 312, while a top mold frame 310 is placed over the substrates 121. Note that the bottom mold frame 312 extends under the substrates 121 and under the terminal aligner insert 304.

**FIG. 3H** depicts a subsequent instance where the bottom mold frame 312 and the top mold frame 310 are brought together to encase the substrates 121 and a portion of the leads 112 that is adjacent to the substrates 121. Note that the top mold frame 310 includes a top leadguide block 314 with a pinch bar, to prevent mold bleeding as detailed below.

**FIG. 3I** is a composite view including perspective view and cross-sectional view that depicts a subsequent instance where a molding operation takes place, wherein a mold material, such as a known polymeric material, is flowed into cavities defined within the bottom mold frame 312 and top mold frame 310. Note that alignment pins 318 may be provided as shown that extend through the clamp 306 and terminal aligner insert 304, as shown in the cross-sectional view.

At **FIG. 3J****,** aa composite view including perspective view and cross-sectional view, a subsequent instance is shown where the bottom mold frame 312 and top mold frame 310 are removed, leaving an assembly of semiconductor device packages, shown as packages 320, still held between the clamp 306 and terminal aligner insert 304.

At **FIG. 3K****,** a subsequent instance is shown where the clamp 306 and terminal aligner insert 304 are removed, leaving an assembly of semiconductor device packages, shown as packages 320.

A hallmark of the assembly process of FIGs. 3A-3K is that the leads 112 are assembled into the packages 320 without lead frames being used.

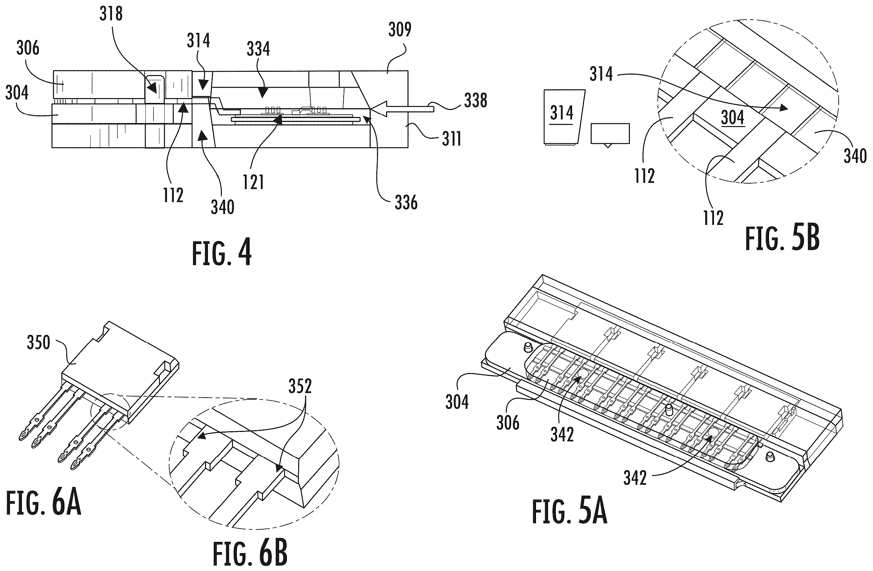

To explain salient features of the present disclosure that enable a lead-frame-less process, FIG. 4 depicts a side cross-sectional view of a transfer mold design, according to the disclosure. In addition to the aforementioned components, the design includes a bottom leadguide 340, which component may form part of the bottom mold frame 312. The design of FIG. 4 further depicts a top cavity 334 and a bottom cavity 336, into which cavities a molding material will be flowed during a molding process. The design of FIG. 4 further includes a top gate block 309, bottom gate block 311, and top gate entry 338. The design of FIG. 4 further includes a top leadguide block 314 with pinchbar.

**FIG. 5A** depicts a top perspective view of the structure of FIG. 4. Note that a set of embedded magnets, shown as magnets 342, are shown. **FIG. 5B** depicts an enlarged view of a pinch bar section of the structure of FIG. 5A. Note that the pinchbar of top leadguide block 314 abuts against the top of a lead 112, as shown in FIG. 4. In this manner, as mold material is flowed into the structure of FIG. 4, mold bleeding outside of the top mold frame 310 and bottom mold frame 312 is prevented. In particular, mold material is not unduly extruded over the leads 112.

**FIG. 6A** depicts a top perspective view of a semiconductor device package 350, according tothe disclosure , while **FIG. 6B** depicts an enlarged view of a lead portion of the semiconductor device package 350 of FIG. 6A. A hallmark of the structure of the semiconductor device package 350 is the presence of pinchbar marks 352, resulting as a part of the aforementioned assembly process, as outlined in FIGs. 3A-3K.

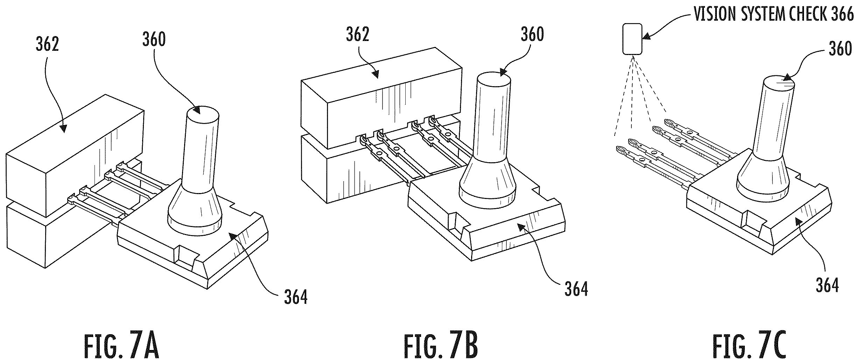

**FIG. 7A** depicts a photographic image view of a testing operation according to the present disclosure. In this instance, leads are clamped and moved sideways within a plane defined by the leads 112. In particular, a pick up tool 360 is provided, together with a movable clamp 362 and sample unit 364.

**FIG. 7B** depicts a photographic image view of another testing operation. In particular, at this stage, the leads are clamped and moved up and down in a direction perpendicular to the plane defined by the leads 112.

**FIG. 7C** depicts a top perspective view of another testing operation where a vision system check 366 is performed to detect bent leads.

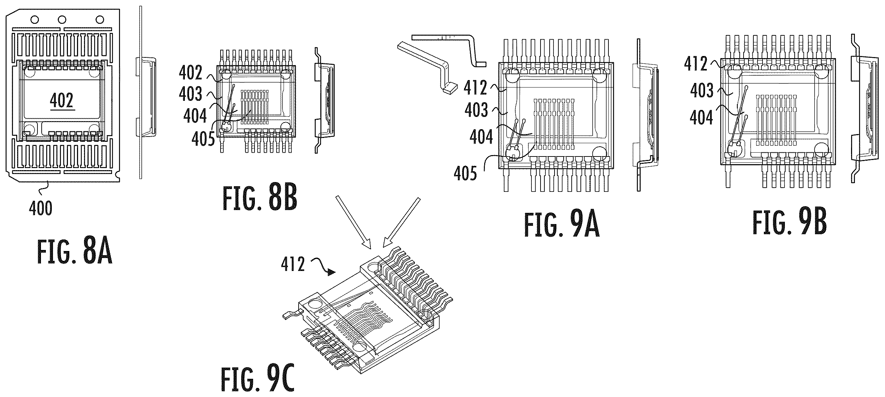

By way of reference, **FIG. 8A** depicts a leadframe assembly 400 with a semiconductor substrate assembly 402 attached. **FIG. 8B** depicts the semiconductor substrate assembly 402 of FIG. 8A after trim and singulation of leads. The semiconductor substrate assembly 402 may include a substrate 403, as well as semiconductor die 404, and wire bonds 405.

**FIG. 9A** depicts an assembly with a semiconductor substrate package 412 with attached leads, according to the disclosure, **FIG. 9B** depicts the assembly of FIG. 9A after a forming operation to bend the leads, as highlighted in the cross-sectional view. **FIG. 9C** depicts a top perspective view of the assembly of FIG. 9B at a final stage.

A difference in the semiconductor substrate package 412 and the semiconductor substrate assembly 402 is that the semiconductor substrate package 412 is not formed using a leadframe. In this example, the semiconductor substrate package 412 has an overall gull wing shape, suitable for surface mount power device applications.

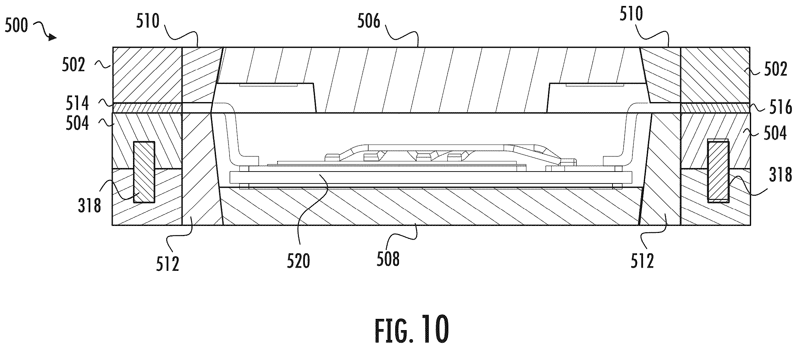

**FIG. 10** depicts a side cross-sectional view of a mold tool layout 500, according to the disclosure. In this example, the mold tool layout 500 may include components that are organized generally according to that described with respect to FIGs. 3A to 5B in particular. As shown, the mold tool layout 500 includes top clamp structures 502, and bottom claim structures 504, arranged on opposite sides of a top cavity bar 506 and bottom cavity bar 508. The mold tool layout 500 is also provided with a set of alignment pins 318, arranged on opposite sides of the top cavity bar 506 and bottom cavity bar 508. The mold tool layout 500 is further provided with a set of top leadguide blocks *510,* with pinch bar, and a set of bottom leadguide blocks 512, each being arranged on opposite sides of the top cavity bar 506 and bottom cavity bar 508. Here a set of leads 514, extends from the left side of the mold tool layout 500, and attaches to the substrate 520, while a set of leads 516 extends from the right side of the mold tool layout 500, and also attaches to the substrate 520, making this arrangement suitable for forming gull wing packages as shown in FIG. 9C.

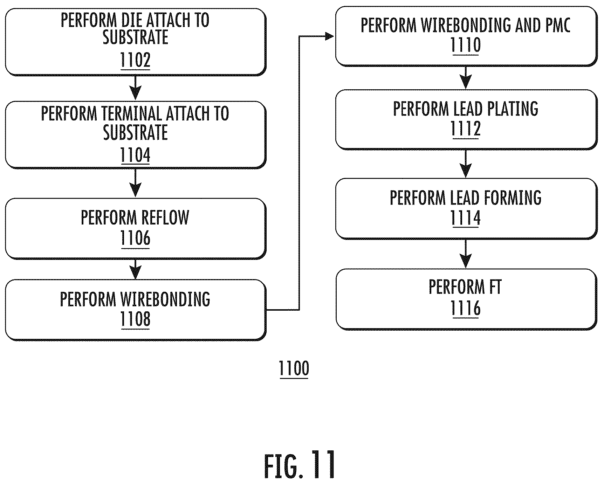

**FIG. 11** presents a process flow 1100, according to the disclosure. At block 1102, a semiconductor die is attached to a substrate, such as a DCB, DAB or AMB substrate.

At block 1104, a terminal (lead) is attached to the substrate. The leads may be attached to respective substrates by a laser welding process.

The attachment of semiconductor die and lead may be performed in an assembly holder as detailed. The assembly holder may accommodate a plurality of substrates, such that the attachment of leads and semiconductor die applies to multiple substrates that are concurrently arranged within the assembly holder, in order to form a substrate assembly that includes substrates with attached leads.

The leads are clamped using a terminal aligner insert and clamp, as detailed hereinabove.

At block 1106 a reflow process is performed, such as a vacuum reflow. In particular, during a soldering reflow process, before a rising temperature is applied inside a chamber, a vacuum is applied to remove gasses to ensure that voids in the solder do not occur.

At block 1108 a wirebonding operation is performed to attach various components including substrates and semiconductor die, to one another, while the components are maintained in the assembly holder.

At block 1110, a molding and a post mold curing ( PMC) operation is performed. The PMC process involves annealing to release package stress before plating. After block 1108, and before the molding operation is performed, the substrate assembly may be removed from the assembly holder. The substrate assembly may remain clamped between the terminal aligner insert and clamp after removal from the assembly holder. The molding operation may employ a top mold frame and bottom mold frame, where the bottom mold frame extends under the substrates and terminal aligner insert.

The top mold frame may include a leadguide block with pinch bar that abuts against the leads of the substrate assembly. During the molding operation, a mold material may be injected into the cavities provided by the top mold frame and the bottom mold frame. The pinch bar may prevent undue mold material from flowing out over the leads during the molding operation.

At block 1112, a lead plating operation is performed. At this instance a housing formed of the molding material extends over the substrates and a portion of leads adjacent to the substrates. At this instance the leads are plated with a plating material, such as a known metallization. Note that after the operation of block 1110, when molding is complete, the substrate assembly is removed from the top mold frame and the bottom mold frame. The substrate assembly is further unclamped and removed from the terminal aligner insert and clamp, before the plating operation takes place.

At block 1114, a lead form operation is performed to properly shape and space the leads. At block 1116, an FT operation is performed, such as by using a Skew tool assembly may for lead conditioning at an FT station or at an offline tool, in order to correct bent leads, especially for a long lead semiconductor device assembly.

In summary, the present disclosure provides a lead frameless assembly structure and process for semiconductor packages, such as discrete power semiconductor packages. Advantages that flow from this approach include reduced manufacturing and packaging cost due to the elimination of a lead frame and elimination of trim and singulation operations. Providing an AMB Si₃N₄ substrate, higher current capability is realized as compared to known Al₂O₃ or AlN DCB type substrates, due to the thicker Cu layer in the AMB approach (e.g., ~ 0.4 mm -0.8 mm). In addition, the ceramic cracking issue is reduced to the higher bending strength and toughness of the Si₃N₄ substrates. Moreover, due to the smaller grain structure, the ability to wirebond for the AMB Si₃N₄ substrate is improved. Additionally, the laser welding operation avoid soldering, leading to higher device reliability by the avoidance of solder in the final package. When AMB substrates are used, there is reduced warpage as compared to known DCB packages, leading to better thermal performance. In particular, an AMB substrate having a coefficient of thermal expansion (CTE) of 2.5 ppm/K, will experience less thermal stress as compared to a DCB substrate having a CTE of 7 ppm/K.

The disclosure further preferably provides an Ag sintered die bonding, leading to a package suitable for higher operating temperature, with lead-free components, free of solder voids, and higher reliability performance. These features provided in a power semiconductor package can maximize device performance for power devices such as SiC.

Further advantages provided by the present disclosure include the ability to quickly prototype new products due to the absence of need for a stamping tool that would otherwise be required for lead frame-based packaging. Thus, because the leads are singulated before joining to substrates, the package lead count can readily be adjusted from 2 leads, 3 leads, 4 leads, 5 leads, 6 leads, 7 leads, etc., according to product requirement. Moreover, the present disclosure covers implementation in gull wing type package architecture with tailored lead count e.g. SMPD 9L, 15L, 21L, etc.).

## Claims

1. A method for forming a semiconductor package, comprising:
performing a lead attachment operation, comprising attaching at least one lead directly to a substrate that is configured to support one or more semiconductor die, wherein the at least one lead is attached to the substrate in singulated fashion.

2. The method of claim 1, wherein the substrate comprises a Si₃N₄ ceramic body, and a set of metal layers that are attached to the ceramic body by an active metal brazing process.

3. The method of claim 1, wherein the substrate comprises a ceramic body and a set of metal layers attached to the ceramic body, and wherein the attaching the at least one lead comprises performing a laser welding operation to join the at least one lead to a metal layer of the substrate.

4. The method of any of the preceding claims, wherein the performing the lead attachment operation comprises placing a plurality of substrates in an assembly holder, placing a terminal aligner insert in the assembly holder, placing a plurality of leads in slots provided in the terminal aligner insert.

5. The method of claim 4, further comprising coupling a clamp to the terminal aligner insert and performing a reflow operation when the clamp is coupled to the terminal aligner insert, and/or
further comprising: arranging the plurality of substrates between a top mold frame and bottom mold frame, and performing a molding operation when the top mold frame an bottom mold frame are joined together to form a mold tool, preferably
wherein the top mold frame comprises a top leadguide having a pinch bar, wherein the pinch bar prevents a mold material from flowing outside the mold tool during the mold operation.

6. The method of any of the preceding claims, further comprising: attaching the one or more semiconductor die to the substrate using an Ag sintering process.

7. The method of any of the preceding claims, wherein the one or more semiconductor die comprises a SiC die.

8. The method of any of the claims 5-7, wherein the mold tool comprises;
a top cavity bar;
a bottom cavity bar; and
a pair of top leadguide blocks that are each arranged with a pinch bar; and
a pair of bottom leadguide blocks,
wherein the pair of top leadguide blocks and the pair of bottom leadguide blocks are arranged on opposite sides of the top cavity bar and the bottom cavity bar.

9. A semiconductor package assembly apparatus, comprising:
a substrate clamp assembly; and
a mold structure, at least partially encasing the substrate clamp assembly, wherein the mold structure comprises top leadguide block, arranged to prevent mold bleeding during a molding operation.

10. The semiconductor package assembly apparatus of claim 9, wherein the substrate clamp assembly comprises:
a terminal aligner insert to align a set of leads for attaching to a set of substrates that are to be arranged within the mold structure; and
a clamp, for coupling to the terminal aligner insert and holding the leads in place.

11. The semiconductor package assembly apparatus of claim 9 or 10, wherein the mold structure comprises:
a bottom mold frame for holding the set of substrates; and
a top mold frame, wherein the top mold frame includes the top leadguide block, and wherein the top leadguide block includes a pinch bar that is arranged to abut against the set of leads, when the top mold frame and bottom mold frame are brought together.

12. The semiconductor package assembly apparatus of any of the claims 9-11, further comprising a set of alignment pins that extend through the substrate clamp assembly and the mold structure.

13. The semiconductor package assembly apparatus of any of the preceding claims 9-12, wherein the mold structure comprises;
a top cavity bar;
a bottom cavity bar; and
a pair of top leadguide blocks that are each arranged with a pinch bar; and
a pair of bottom leadguide blocks,
wherein the pair of top leadguide blocks and the pair of bottom leadguide blocks are arranged on opposite sides of the top cavity bar and the bottom cavity bar.

14. A semiconductor substrate assembly, for forming a semiconductor device package, comprising:
a substrate, the substrate comprising a ceramic body and a set of metal layers attached to the ceramic body; and
a set of leads, attached to the substrate, wherein the set of leads are adjoined to the substrate through a laser weld.

15. The semiconductor substrate assembly of claim 14 with one or more of the following:
- wherein the substrate comprises a Si₃N₄ ceramic body, and a set of metal layers that are attached to the ceramic body by an active metal brazing process;
- wherein the set of leads comprises a universal press fit lead;
- wherein the set of leads are attached to the substrate in a gull wing arrangement.
